Europäisches Patentamt

European Patent Office

Office européen des brevets

(11) Publication number: **0 416 731 A2**

## EUROPEAN PATENT APPLICATION

(21) Application number: 90307982.0

(51) Int. Cl.⁵: **G01R 13/00**, G06F 3/023

(22) Date of filing: 20.07.90

(30) Priority: **08.09.89 US 404929**

(43) Date of publication of application:
**13.03.91 Bulletin 91/11**

(84) Designated Contracting States:
**DE DK FR GB**

(71) Applicant: **Hewlett-Packard Company**
**Mail Stop 20 B-O, 3000 Hanover Street**
**Palo Alto, California 94304(US)**

(72) Inventor: **Nungester, Richard L.**
**E 9808 9th Avenue**
**Spokane, Washington 99206(US)**

(74) Representative: **Colgan, Stephen James et al**
**CARPMAELS & RANSFORD 43 Bloomsbury**
**Square**
**London WC1A 2RA(GB)**

(54) Simplified interface and method of operation for multi-function apparatus.

(57) A multi-function apparatus has its subassemblies configured to perform a number of functions by an internal processor, stored programs, and user selected inputs. A display is included for showing screen configurations, each of which indicates a sub-instrument or application of the apparatus. Each screen configuration includes a plurality of control point fields which are selected from a limited set of types of control point fields common to all screen configurations. Each type of control point field, when selected by the user, enables the performance of a predetermined operation incident to the function. A user operable rotary input device enables selection of any displayed control point field. All functions performable by the multi-function apparatus are operated through user interaction with and selection of one or more control point fields, the commonality of the control point fields providing increased ease of user operation of the apparatus. A preferred embodiment of the invention includes a multi-instrument test system particularly adapted to the testing and measuring of signals from and to radio frequency apparatus.

## FIG. 1

## SIMPLIFIED INTERFACE AND METHOD OF OPERATION FOR MULTI-FUNCTION APPARATUS.

### FIELD OF THE INVENTION

This invention relates to processor-controlled apparatus which performs multiple functions, each function being controllable by and through a user interface. More particularly, this invention relates to a user interface which is common to a plurality of test instruments, all of which are common to a single apparatus embodiment.

### BACKGROUND OF THE INVENTION

With the availability of sophisticated microprocessors, equipment designers have found it both possible and practical to integrate, within a single apparatus, separate electronic devices which perform multiple, substantially independent functions. In the field of electronic test equipment, this has been more the rule than the exception in recent years. Electronic test equipments are now available which perform multiple, separate instrument functions with all the circuitry necessary to carry out those functions housed on a single chassis.

A technical challenge for the designer of those equipments has been to provide a user interface which is not overwhelming to the user in its complexity and difficulty of use. Previous attempts to integrate multiple instruments into a single apparatus have resulted in substantial complexity in the user interface. Some have employed multiple types of input transducers for controlling the test equipment or instrumentation. For example, input transducers have included push and release buttons, push-in/toggle-out buttons, light pens, a mouse, knobs, touch screens, etc, etc. To a large extent, prior implementations of control functions have been a reproduction of the controls previously required for the separate instruments, with some attention given to a modest level of integration. Thus, notwithstanding the potential cost and functional benefit gains from integrated instrumentation, the user is often beset with a long education period to enable efficient use of the instrument's functions.

Accordingly, an object of this invention is to provide an improved user interface for a multi-function apparatus.

It is another object of this invention to provide a multi-function apparatus with a user interface which is common to all functions.

Another object of this invention is to provide an improved interface for a multi-function apparatus which enables user input of variables in any desired order.

It is a further object of this invention to provide a user interface for a multi-function test instrument, such interface having a small number of control point manifestations for many test functions.

It is yet another object of this invention to provide a control panel for a multi-function apparatus which has a plurality of control devices enabling alternate methods for function control.

### SUMMARY OF THE INVENTION

The described multi-function apparatus employs processor control means, stored programs and user selected inputs to configure subassemblies within the apparatus to perform a number of functions. Display means are included for showing screen configurations, each of which indicates a function of the apparatus. Each screen configuration includes a plurality of control point fields which are selected from a limited set of types of control point fields common to all screen configurations. Each type of control point field, when selected by the user, enables the performance of a predetermined operation incident to the function. User operable input means enable selection of any displayed control point field. All functions performable by the multi-function apparatus are operated through user interaction with and selection of one or more control point fields, the commonality of the control point fields providing increased ease of user operation of the apparatus. A preferred embodiment of the invention includes a multi-instrument test system particularly adapted to the testing and measuring of signals from and to radio frequency apparatus.

### DESCRIPTION OF THE DRAWINGS

Fig. 1 is an elevation view of a control panel interface for an instrument which embodies the invention.

Fig. 2 is a functional block diagram of the main subassemblies within the instrument of Fig. 1.

Fig. 3 is a representative screen viewable by the user which shows the control point fields for Receiver Test applications.

Fig. 4 is a representative screen viewable by the user on the display which shows the control point fields for Transmitter Test applications.

Fig. 5 is a representative screen viewable by the user on the display which shows the control point fields for the Low Frequency Analyzer sub-instrument.

Fig. 6 is a representative screen viewable by the user on the display which shows the control point fields for the Radio Frequency Source sub-instrument.

Fig. 7 is a representative screen viewable by the user on the display when the instrument is configured as an Oscilloscope.

Fig. 8 is a representative screen viewable by the user on the display of the instrument when it is configured as a Spectrum Analyzer.

Fig. 9 is a state diagram showing the various states which occur during a user's interaction with a Numeric Entry Field.

Fig. 10 is a state diagram showing the various states which occur during a user's interaction with a String Entry Field.

Fig. 11 is a state diagram showing the various states which occur during a user's interaction with a One-Of- Many Field.

Fig. 12 is a state diagram showing the various states which occur during a users interaction with an Immediate Action Field.

Fig. 13 is a state diagram showing the various states which occur during a users interaction with a Measurement Unit Field.

Fig. 14 is a state diagram indicating the operation of the invention when an operation to be performed is dependent upon more than one variable input.

## DETAILED DESCRIPTION OF THE INVENTION

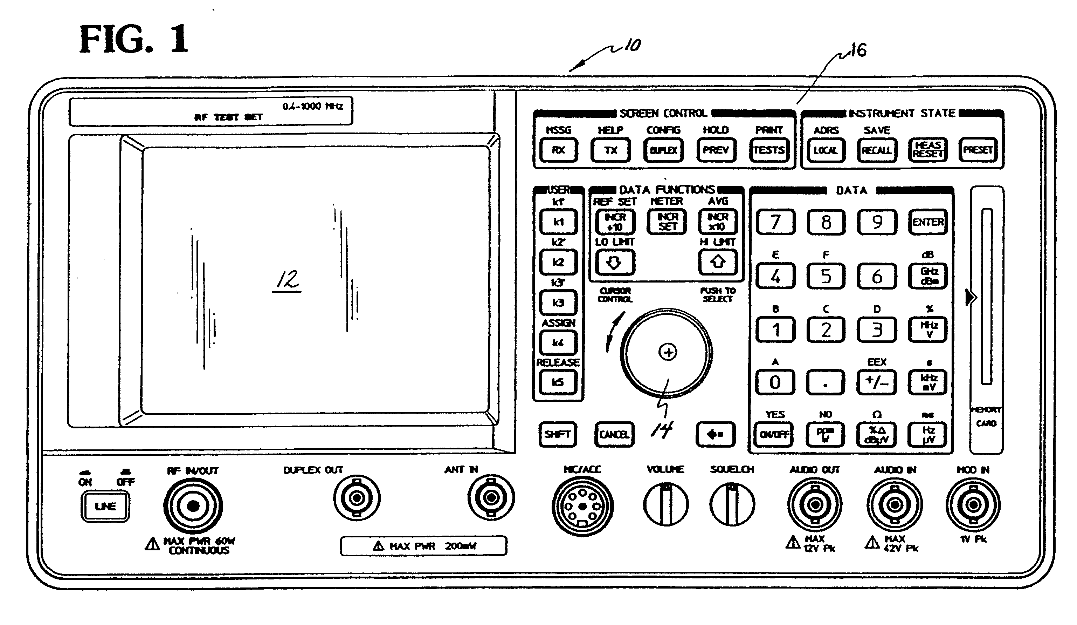

Referring now to Fig. 1, a radio frequency test set is shown which is provided with a user interface or control panel 10. A plurality of keys are arrayed about the face of control panel 10 next to a display 12. Display 12 may be a cathode ray tube, plasma display panel or other appropriate display instrumentality for viewing by the user. Along the bottom of control panel 10 are a plurality of input/output connectors, rotary controls and switches. The instrument shown in Fig. 1 is a multi-function apparatus which has the capability to carry out the functions of: receiver test, transmitter test, duplex test, audio and radio frequency sources, audio and radio frequency analyzers, spectrum analyzer, oscilloscope and others.

With such a variety of functional capabilities, there is no practical way that individual control panels for each function can be provided at a reasonable cost on size basis, or would be accepted by the user. Furthermore, even if such individual control apparatus could be provided, the user would quickly be overwhelmed by the complexities incident to learning how to control so many individual controls. This invention provides a limited set of input keys, a rotary pulse generator with a push/release action and data shown on display 12 to provide all of the controls for the multiplicity of functions performed by the instrument.

During the operation of the instrument, it will be understood that a plurality of "screens" are shown on display 12 to enable the user to control the operations to be carried out during the performance of the "function" contemplated by the screen. In the embodiment shown in Fig. 1 and to be discussed in further detail below, each screen is approximately "an instrument". The term "function" will be employed to broadly describe the measurements, signal sources, or other operations being carried out when the instrument is configured as noted on a screen.

The most often used control on panel 10 is rotary pulse generator 14 (hereinafter called RPG). The user may rotate RPG 14 clockwise, counterclockwise,or may depress it to cause a "select" action to occur. RPG 14 is, in essence, a quantized rotary transducer which provides pulse inputs to a microprocessor within the instrument. These pulses enable the selection of various screens, selection of various control point fields within each screen, and generally enable the user, through a single control device, to completely control substantially all functions and operations performable by the instrument. This is vital from the user's viewpoint, as once he/she understands the simple three movements of RPG 14, the functions and operations of the instrument may be controlled. The user is enabled to "feel" the rotation of RPG 14 by detents (not shown) which enable the user to both hear" the rotation and feel a ratcheting effect. The remaining keys shown on control panel 10 provide user shortcuts but, in the main, duplicate functions carried out by RPG 14.

Keyboard area 16 of control panel 10 has five main groups of keys which, as above stated, provide shortcuts for user control of the instrument. While all of the keys are important for the functioning of the instrument, many are not directly relevant to the invention being here described and, thus, will be only referred to in passing. The five main groupings of keys include: screen control, instrument state, user, data functions, and data. Three additional keys at the lower left corner of keyboard area 16 are the shift, cancel and backspace keys. It will be noted that in addition to on the face of the key, above most of the keys, there is an additional function indicated. A press and release of the shift key causes the function of certain keys to be that indicated above the key, rather than on the key.

Each screen control key may be pushed at any time during the instrument's operation and causes the display of the screen called for by the particular key. For instance, depression of the RX key causes a Receiver Test screen to be shown on display 12.. Depression of PREY key causes the immediately preceding screen to be shown on display 12. etc. The user key grouping includes five keys, k1-k1, k1'- k3', assign and release. Keys k1-k5 are assigned, on a screen by screen basis, and are used to bypass the use of RPG 14 and to move from field to field on the screen currently displayed (the term field will be described below).

Each of keys k1-k5 is assignable by the user to a location on the face of display 12, as contrasted to a particular field shown at that location. Frequently, an operation will cause one field to replace another field at the same position on display 12. It is desirable that a user key associated with the first field become associated with the replacement field. Thus by assigning a user key to a location on display 12, the select function initiated by a depression of the user key occurs for whatever field is shown at that location. Keys k1'-k3' are "global" user keys and are used to "pull" a field from one screen to another. For instance, a setting may be displayed in one field on a screen which is important for the user when operating on another screen. By depressing one of keys k1'-k3', that field can automatically be viewed on any screen shown on display 12.

The data function keys provide various setting shortcuts and measurement value display options. The INCR -10 and INCR x 10 keys enable numeric values shown in a field to be incremented by various amounts more rapidly. The data keys include the normal alphanumeric keys and a plurality of units keys which enable entry of the fundamental quantities being measured, i.e., frequency, power, potential, resistance, time, etc.

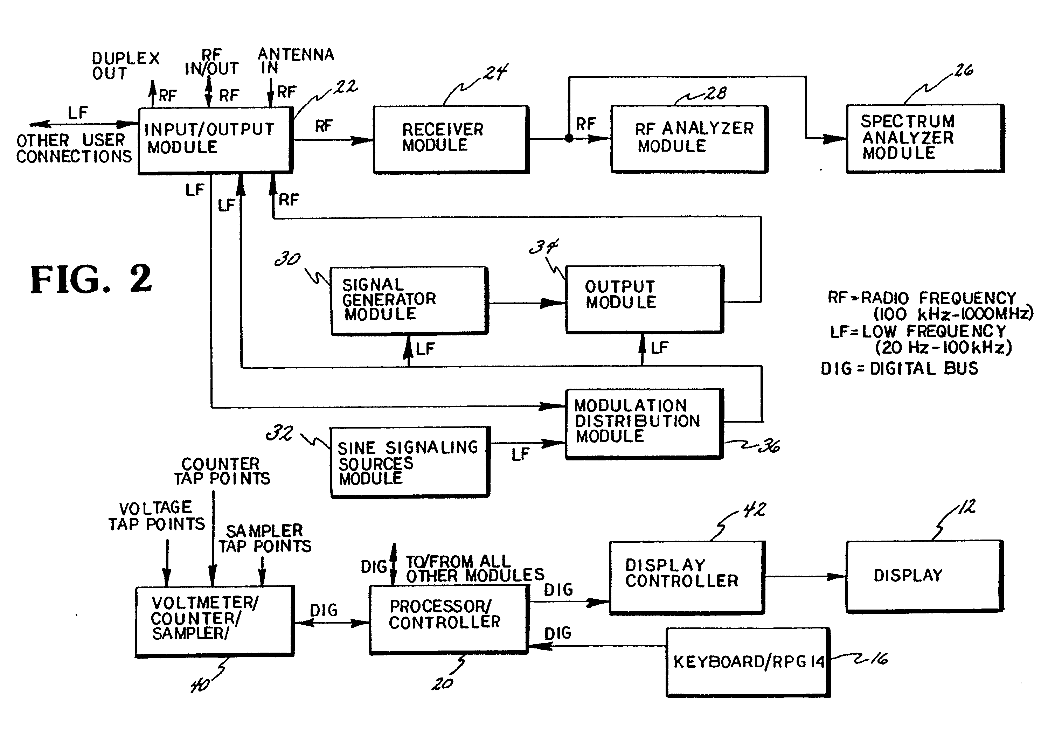

Referring now to Fig. 2, a block diagram is illustrated showing the various subassemblies within the instrument of Fig.1. As aforestated, the instrument provides a plurality of functions which are controllable through a user-friendly interface. The instrument's operation is under the control of processor/controller 20 which provides real-time operational control. The instrument includes a plurality of modules, each of which is configurable in conjunction with other modules, to provide the called-for instrument function.

Input/Output Module 22 is the main interface to the unit under test. Three of its interconnection ports are shown, i.e., Duplex, RF, and Antenna, but it is to be understood that additional ports are present for other test functions. Receiver 24 receives RF inputs, and provides demodulated signals to various analysis instrumentalities. Spectrum analyzer 26 and Radio Frequency analyzer 28 are, as their names suggest, analysis devices which perform the well-known functions associated with those instrumentalities. Signal generator 30 and sine/signalling sources 32 enable the generation of audio frequency, radio frequency, and modulation signals necessary for the various instrument function. Output module 34 provides additionable selectable output connections to a system under test and modulation/distribution module 36 is a distribution network enabling various signals and modulated signals to be directed, under processor control, to various other modules. A voltmeter, counter, sampler module 40 provides measurement of signal values to controller 20 which, in turn, operates display controller 42 and display 12. As will be recalled, display 12 can be configured to show any of a plurality of screens, each screen equivalent to a sub-instrument implemented by the invention.

Processor/controller 20, under control of keyboard 16, RPG 14 and stored software, configures each of the modules shown in Fig. 2 into the called-for functional instrument. Thus, if the instrument is to be used as an RF source, processor controller 20 connects signal generator 30 to an output port in input/output module 22 where the signal is passed to unit under test. Similarly, if the instrument is to be configured as an oscilloscope, input/output module 22 has certain of its inputs connected to voltmeter, counter, sampler module 40 which converts the signals to digital values which, are employed by display controller 42 to indicate on the display 12 the well known oscilloscope-type trace.

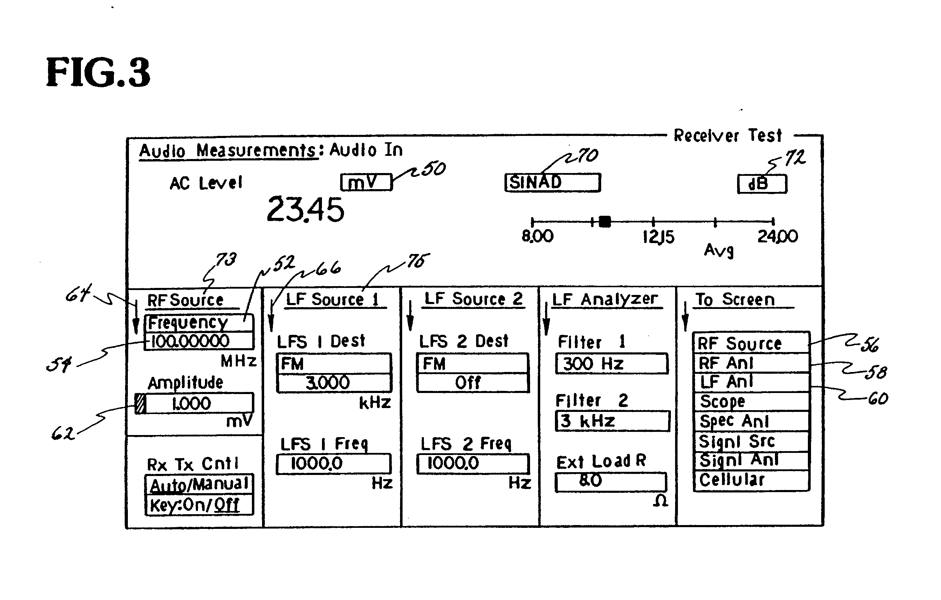

Referring now to Figs. 3-8, representative screens will be described, each of which illustrates an instrument application or sub-instrument. In Fig. 3, the Receiver Test Screen is shown as it would be seen on display 12. All screens contain display areas which are referred to as "control point fields" or "fields". The control point fields in Fig. 3 are illustrated as those portions of the screen which are enclosed by a small rectangular box, e.g.,. 50, 52, 54, 56, 58, 60, etc. Each control point field is accessible by the user through the placement of a cursor indicator 62 immediately to the left of the indicated box. RPG 14 controls the movement of cursor 62 about the face of the screen. Clockwise rotation of RPG 14 causes cursor 62 to move from field to field in a cyclic and reproducible manner. For instance, assuming that cursor 62 is placed next to field 50, rotation of RPG 14 by one "click" clockwise causes cursor 62 to move to sinad field 70 then to the dB field 72 and then to move down the fields in the RF source column 73 of the screen, in the direction shown by arrow 64. When the cursor comes to the last field in the RF source column 73, it proceeds to the top of LF source 1 column 75 and again moves downwardly, from field to field as shown by arrow 66. The cursor continues to move in an identical fashion through each succeeding columnar area of the screen until it returns to field 50, where continued rotation of RPG 14 will again cause it to retrace its previous steps. Counter clockwise rotation of RPG 14 causes the exact opposite movement of cursor 62.

This preferred embodiment of the invention includes five separate types of control point fields, i.e., numeric entry; string entry; one-of-many; immediate action; and measurement unit. As will be understood, it is not necessary for the user to know the type of field shown on the screen. The user's operation of RPG 14 and observation of what happens within a particular field in response, indicates to the user the type of field.

The numeric entry field allows entry of numeric values as well as the incrementing of the values or offsetting them by use of either the INCR SET key or the REF SET key. A string entry field causes a menu of selectable characters to be displayed and allows RPG 14 to select from among them so as to build up ah arbitrary string of characters in the field area. A one-of-many field causes a menu of selectable choices to be displayed and allows RPG 14 to select from among them. An immediate action field causes an event to occur immediately upon pushing RPG 14 when the cursor is adjacent the field. A measurement unit field enables discrete control of the way a measurement is made and displayed. It also causes a menu to be displayed (e.g. low limit, high limit, ref. set, average, meter etc.) which enables the user to select, through the action of RPG 14, which of a number of display formats may be used to view measurement results.

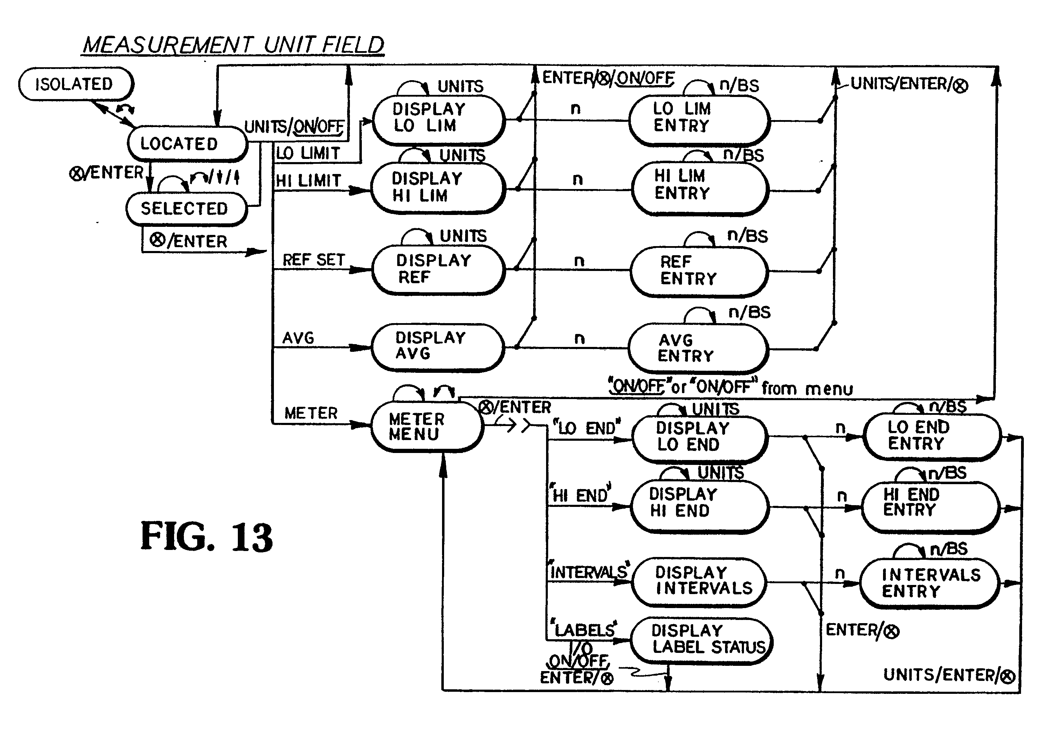

Referring to the Receiver Test screen shown in Fig. 3, control point field 50 is a measurement unit field which becomes operative when the cursor 62 is adjacent to it. Under those circumstances, a depression of RPG 14 causes selection of field 50 and displays a list of measurement units and other display format options in the lower right area of the screen. When the desired unit or other optional format is reached by rotating RPG14, a subsequent depression of RPG 14 selects the specific unit or format and releases the cursor so it can be moved to the next control point field. Other functions are performable in a measurement unit field and these will be considered in the discussion below of the measurement unit state diagram of Fig. 13.

To the right of control point field 50 is a one-of-many field 70. The placement of cursor 62 next to field 70 and the subsequent depression of RPG 14 enables the operation of that field and causes a menu to appear in the lower right area of the screen in place of the "To Screen" indications. Cursor 62 slides up and down the menu list under control of RPG 14 and when RPG 14 is depressed a selection is made, the selection appears in field 70 and cursor 62 returns to its position next to field 70. After selection of the desired measurement, the next clockwise click of RPG 14 moves cursor 62 to control point field 72. This field is again a measurements unit field and a subsequent depression and rotation of RPG 14 enables the desired measurement units to be viewed and selected. The selections effected by RPG 14 in control point fields 70 and 72 establish the measurement to be made and the units in which the measurement is to be made. The subsequent operations performed by the user enable the instrument "set-up" to be configured.

Continued rotation of RPG 14, positions cursor 62 next to control point field 52. Field 52 is a one-of-many field, displays either "frequency" or "offset frequency" and allows selection of one or the other. The movement of cursor 62 to control point field 54 and depression of RPG 14 causes the selection and operation of Field 54. This field is a numeric entry field which enables a frequency to be entered for the output frequency stimulus to be fed to the antenna of a receiver under test. Subsequent movements of cursor 62 through the control point fields in the RF source column 73 enables the RF signal's amplitude to be set and for certain control functions to be set. Continued rotation of RPG 14 causes cursor 62 to move to LF source 1 column 75 and to move down through the various control point fields.

The stimulus signals are passed to the receiver-under-test through one of the connectors on control panel 10 ( see Fig. 1). The LF analyzer column is employed to set filters and an external load resistance for the incoming audio signal so that it can be measured and its ac level shown in the upper box portion of the Receiver Test screen. The right most column of the Receiver Test screen is common to many of the screens and provides the user with an ability to move from screen to screen simply by placing the cursor next to one of the indicated immediate action fields and depressing RPG 14 to select the indicated screen. Upon such selection, the chosen screen replaces the screen on the face of display 12. Each of control point fields 56, 58, 60, etc. are immediate action fields, which upon positioning of cursor 62 and selection by RPG 14, is caused to immediately enable the action called for in the field.

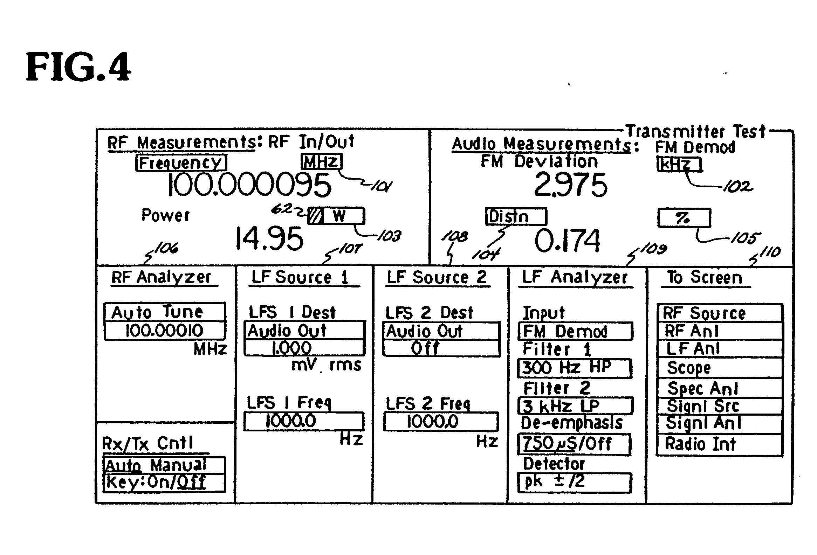

In Fig. 4, a Transmitter Test screen is shown and it will be seen that it bears substantial resemblance to the Receiver Test screen of Fig 3. This screen enables both RF and audio measurements to be taken as indicated. Here again, the various control point fields on the screen are located by the movement of cursor 62 through control point fields 100, 101, 102, 103, 104, 105 and then vertically through the control point fields in screen columns 106, 107, 108, 109 and 110.

Until now, RPG 14 has been described as the main user control which enables location of a control point field, and the modification of its contents to thereby instruct the instrument as to how to configure itself. As the user becomes more familiar with the instrument, additional keys enable alternative input capabilities. For instance, each of user keys k1-k5 may, for each screen, be assigned a particular position on the display. Thus, rather than rotating RPG 14 to cause the movement of cursor 62, one of keys k1-k5 can be depressed, such action causing the immediate movement of cursor 62 to the pre-assigned position. It should be noted that when the uer assigns a location to one of keys K1-K5, a small icon (e.g. a"1", '2" etc) appears at the location on the screen. Thus, for each indicated screen, there are 5 preset positions to which cursor 62 can be moved with a single keystroke of one of keys k1-k5. When a numeric entry field is reached, in lieu of rotating RPG 14 to sequentially increment the numerals in the control point field, various data keys can be depressed to enter a new value directly. It can thus be seen that these keys provide shortcuts to the use of RPG 14 and are provided for the more sophisticated user.

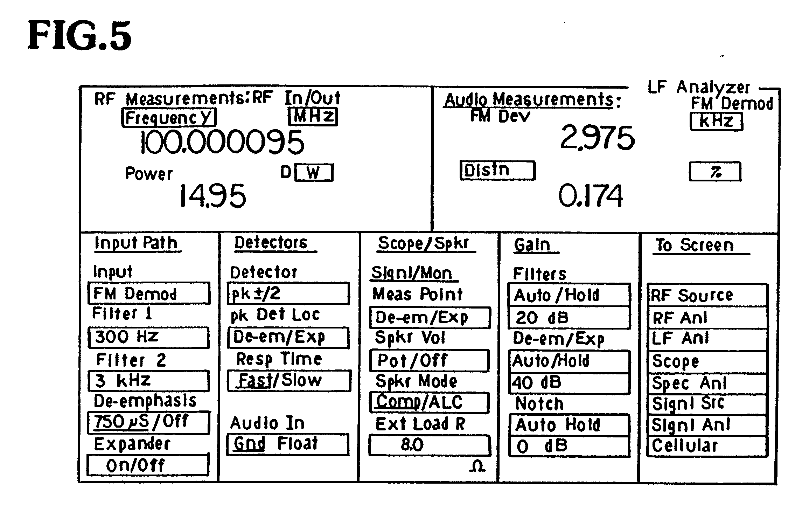

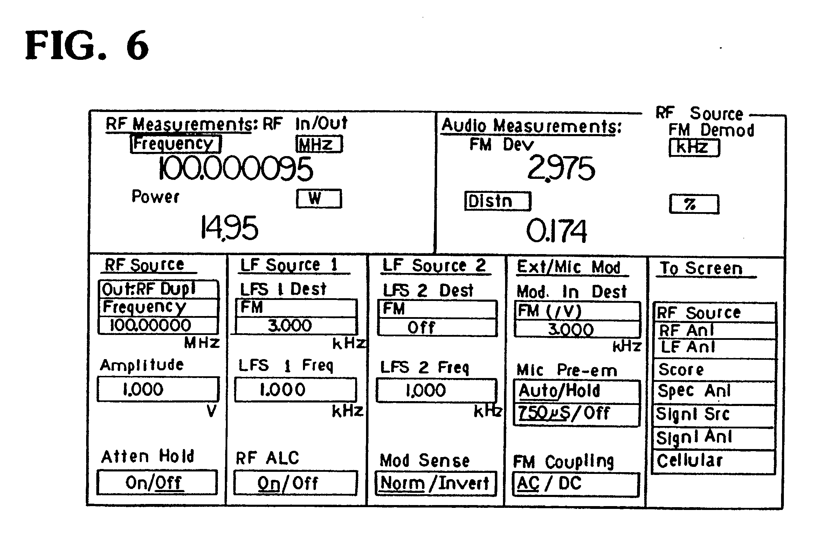

Referring now to Figs. 5 and 6, the Low Frequency Analyzer and RF Source screens are shown. The Low Frequency Analyzer screen indicates that the instrument is set up to provide low frequency signal analysis in accordance with the illustrated control point fields. In Fig. 6, the RF Source screen indicates that the instrument is configured as an RF generator. Here again, the configuration of the instrument is altered by the user setting the various control points within each of the indicated control point fields.

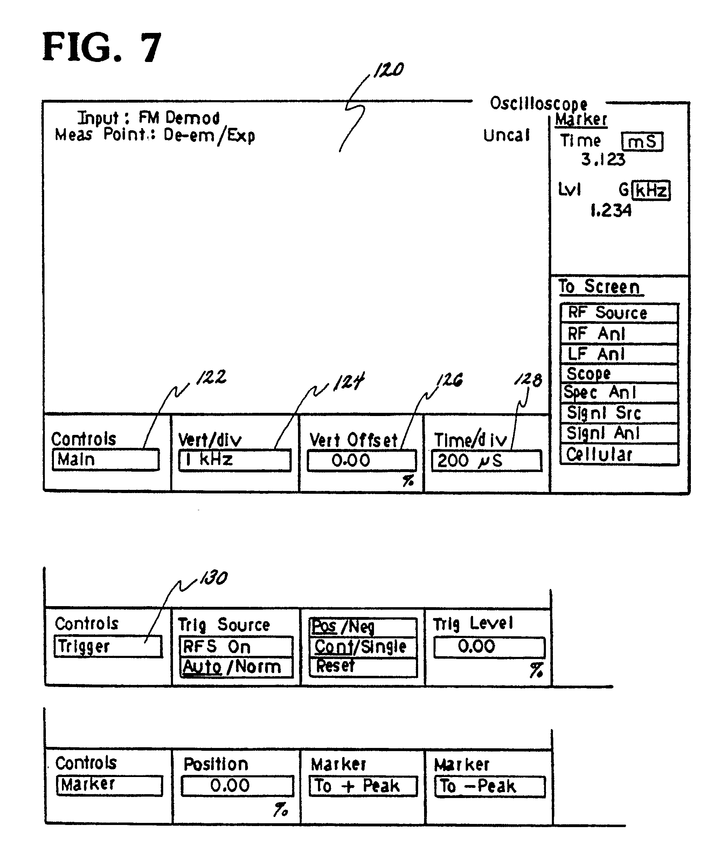

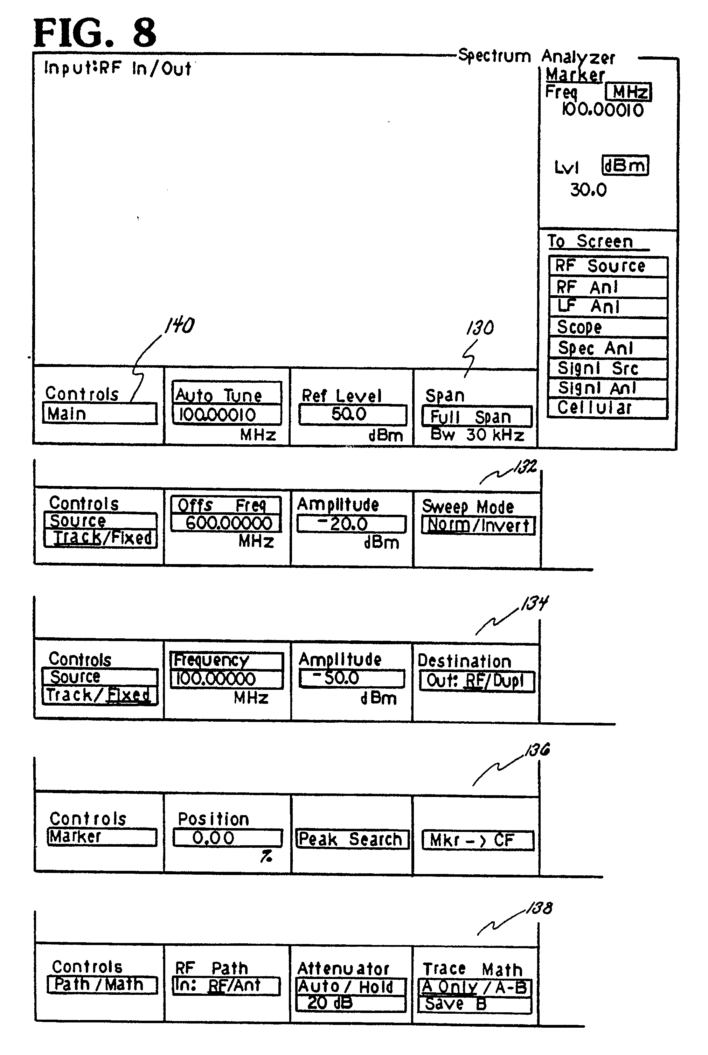

In Figs. 7 and 8, screens are shown which are displayed when the instrument becomes configured either as an Oscilloscope or a Spectrum Analyzer. When in the Oscilloscope state, a signal trace will appear in area 120. The control points for the Oscilloscope are set by moving the cursor through control point fields 122, 124, 126, and 128. Control point field 122 is one-of-many field which, in its initial setting indicates "main". That setting enables the subsequent input of the vertical divisions into control point field 124, vertical offset divisions into control point field 126 and time per division into control point field 128. Then, the cursor is moved back to control point field 122 by RPG 14, RPG 14 is depressed and then subsequently rotated to cause the indication "trigger" to appear in the field as shown at 130. When this occurs, each of the control point fields to the right changes its indication as shown, thereby enabling additional control points to be set into the Oscilloscope function. When the "controls" control point field is again incremented to indicate "marker", the control point fields to the right are altered as shown, thereby enabling the entry of additional control points.

Fig. 8 indicates the screen for a Spectrum Analyzer function with screen areas 130, 132, 134, 136 and 138 sequentially being displayed as control point field 140 is incremented from "main" to "source" (with two sub categories, i.e., either "track" or "fixed") to "marker" and then to "path/math".

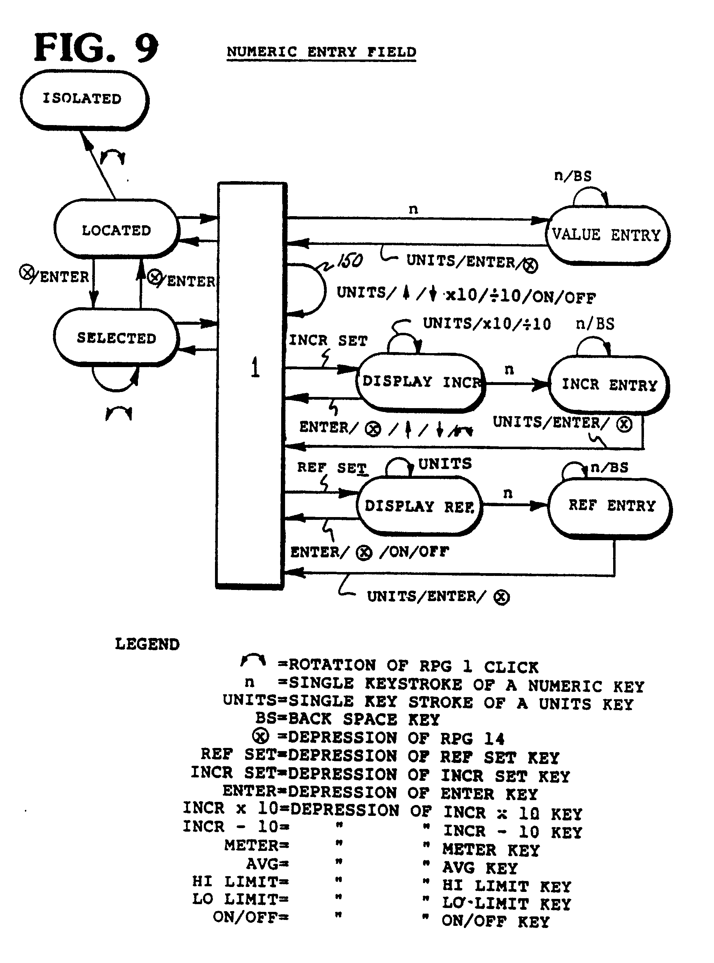

In Figs. 9-13, state diagrams are shown which indicate the various states which occur and the movement therebetween when either RPG 14 or one or more of the keyboard keys is operated. These state diagrams indicate to one skilled in the art the operation of the instrument's user interface control software.

Referring first to the numeric entry field state diagram shown in Fig. 9, attention should first be paid to the legend which indicates the meaning of the various icons used in the state diagram. It should also be noted that whatever state is started from (i.e. Selected or Located) is the state returned to. Further, Ref Set or Incr Set keystrokes when in any of the five right-most states in F169, lead to Display Ref or Display Increment states respectively.

At the upper left of Fig. 9, it can be seen that the rotation of RPG 14 causes the cursor to move among the fields as aforedescribed. Once the cursor arrives at a the numeric entry field, the field is in the located state. By then depressing RPG 14, the field traverses to the selected state, at which point, rotation of RPG 14 enables the incrementing or decrementing of the number shown in the field. The user escapes from the selected state by again depressing RPG 14 and returns to the located state. The user can also proceed directly from either the located state or the selected state to any of the three states shown to the right of the figure. Thus, if in the located state and a number key on the keyboard is depressed, the field immediately enters into the value entry state with the digit just entered being displayed. By depressing a number key or the backspace key, the user cycles through the value entry state, each time providing a new digit. The user may depart from the value entry state by either depressing a units key, the enter key or depressing RPG 14. This method of numeric entry is an alternative to rotation of RPG 14 while in the selected state.

As shown at 150 in Fig. 9, the depression of a units key, up key, down key, etc. from either the located or selected states, enables the indicated function in the field to be carried out. For instance, depression of the units key (e.g. watts, dbm, etc.) causes the indicated numeric entry to be converted to the units value indicated. Thus, if the numeric entry field shows .001 W, depression of dbm will cause 0 dbm in the numeric entry field to appear (i.e., .001 watts = 0 dbm).

Depression of the INCR SET key causes entry into the display increment state. The increment value can be modified by entering a number from the key pad, causing the increment entry state to be entered and the new increment created. The increment entry state is departed by pressing either a units key, the enter key, or RPG 14, as the case may be. The final state is, as indicated in the notes at the bottom of Fig. 9, whatever state was started from, i.e., either located or selected.

It is often desirable to set a reference level so that a setting can be made from a preset datum level. This is accomplished by the Ref Set key which, when depressed places the field in the display Ref state, allowing viewing of the current reference value. In this state, the reference may be any number which is relevant to the setting. For instance, if a frequency setting is being made, one may wish to set the deviation from a base frequency. In such case, the reference would be a base frequency so that only the deviation amount is shown and not the base frequency. To insert a reference setting, a numeric key is depressed while in the display reference state,causing the field to go into the ref entry state, whereby the new reference can be entered. The ref entry state is departed by depressing either a units key, the enter key or RPG 14, as the case may be. If, after displaying the reference, it is decided that no modification of the references is required, that state can also be departed by providing one of the indicated actions.

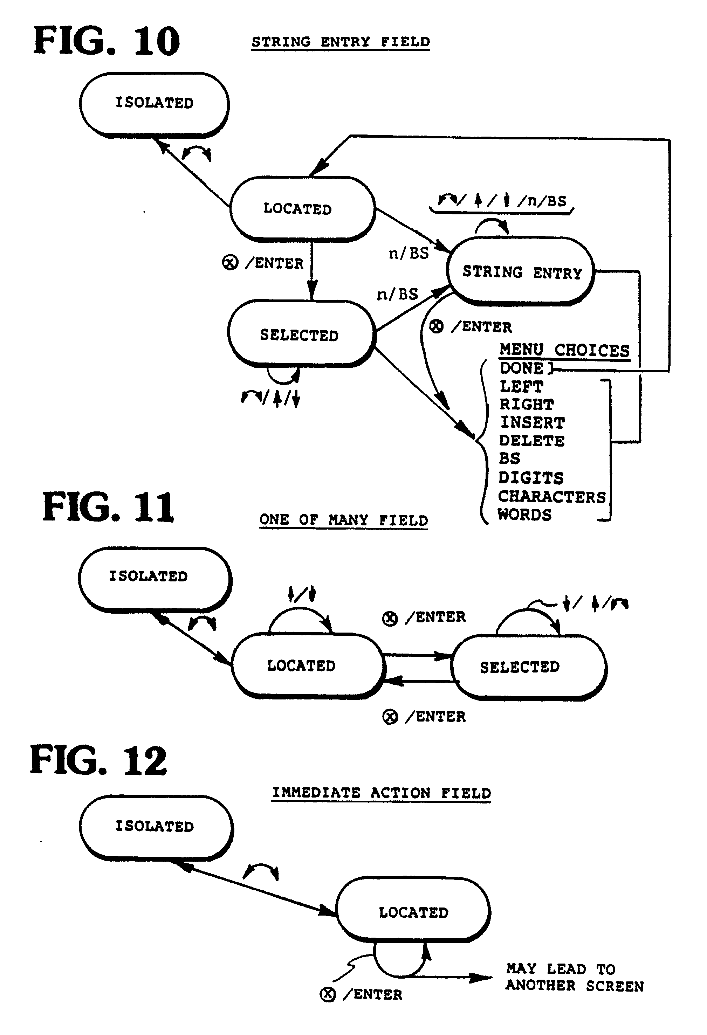

Turning now to Fig. 10, the state diagram for a string entry field is shown. A string entry is generally utilized to insert alphanumeric data in a portion of a screen reserved for messages. The legend shown in Fig. 9 is applicable to the state diagram of Fig. 10 as well as the remaining state diagrams. It can be seen from an examination of Fig. 10 that the string entry state may be entered from either the located or the selected state. When the string entry state is entered, a menu, shown at the lower right of Fig. 10, is displayed thereby enabling one or more of the indicated functions, digits, characters or words to be accessed by positioning the cursor next to the menu choice. Thus, a list of alphanumeric characters can be inserted by simply positioning the cursor next to the displayed menu item, depressing RPG 14 to cause the entry of the item and repositioning the cursor, etc.

In Figs. 11 and 12, state diagrams are shown for the one-of-many and immediate action fields. The one-of-many state diagram indicates that once in the selected state, a menu of choices appears in the lower right of the screen. The movement of RPG 14 or the up or down keys causes the cursor to move up or down the list of choices. If there are more entries than will fit in the alloted screen area, the list scrolls one entry per "click" of RPG 13. A push of RPG 14 or depression of the enter key causes a return to the located state and makes the indicated selection. Each time the cursor is placed next to a menu selection, there are two modes of operation possible. One is that the instrument configures itself as commanded whether or not the menu item is selected, and the second is that the instrument is only configured as commanded when the particular menu item is selected. In the main, most one-of-many fields employ the latter mode, while a few the former mode (e.g.,in an oscilloscope time per division field, each time the setting is changed, the oscilloscope trace is altered to reflect the new setting.

The immediate action field state diagram indicates that the depression of RPG 14 or the enter key causes the immediate action indicated in the field to be performed. A typical use of such a field would be to go to another screen.

Turning now to Fig. 13, a state diagram is shown for a measurement units field. This diagram commences in a manner similar to the other state diagrams, except that once the selected state is entered, a menu appears containing a list of all the keystrokes which can be pushed when in either the located state or selected states. Pushing one of these keys (such as low limit, high limit, ref set, AVG, or meter) or picking one from the menu, causes the movement to a display state where the indicated measurement modifier is shown in the field. Then, by entering a number from the alphanumeric keypad, any of the aforestated measurement modifiers can be altered. A depression of the meter key causes a second menu to be displayed indicating low end, high end, intervals, and labels. In a similar way, these can be modified.

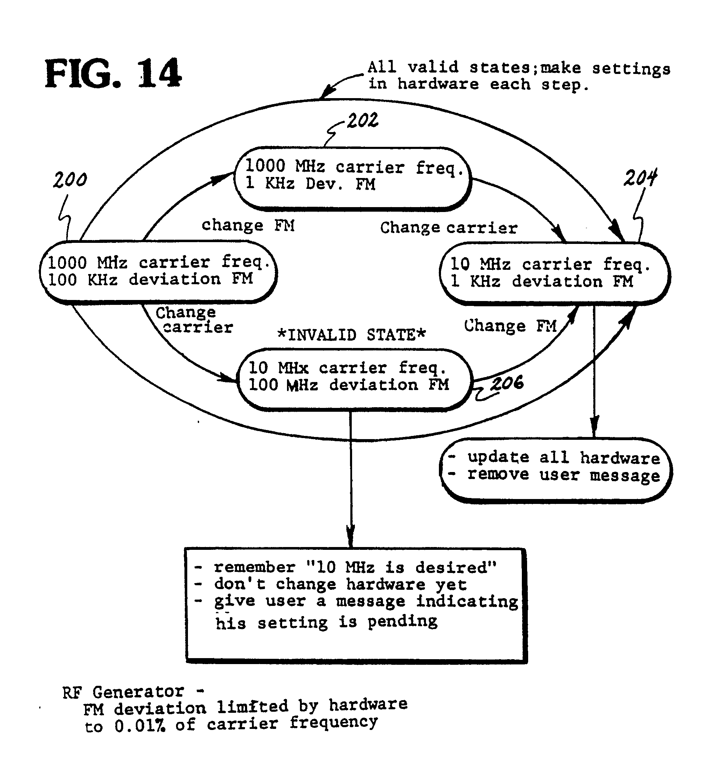

During the operation of the invention, entries into fields are often "coupled". This occurs because the instrument's capabilities are hardware limited, making the instrument unable to perform certain operations, notwithstanding insertion of specific entries into the various fields. For instance, as shown in the state diagram of Fig. 14, the instrument displays the RF source screen and is producing 1000 MHz with a 100 kHz FM deviation imposed thereon. If the FM deviation is limited by the instrument's hardware to only 0.01% of the carrier frequency, the entry of a higher percent of carrier FM deviation or lower carrier frequency will create an invalid state.

When two or more inputs are required to define the state of a given instrument, the two or more inputs are said to be "coupled". Frequently, coupled input settings force entries to be made in a certain sequence when moving among valid instrument hardware states. In such situations, the acceptable range of entries for a given setting must change as a function of the current values of all other input settings in the group. When the first input of a group of coupled inputs is entered in a field that would cause an invalid combination and would not be allowed, the entry becomes "pending" (e.g. as indicated by flashing, by a different color background, or by some other indication) until all of the entries are made which enable the operation to be performed. Until all entries are properly received, the instrument stays wherever it used to be and the display shows the user entered values as pending.

As shown in Fig. 14, the initial state 200 may be modified by a change of the FM entry thus causing movement to state 202. State 202 is a valid state and the hardware is modified accordingly. Then, if a subsequent change is made to the carrier frequency, a new state 204 is created which is then fully implemented by the instrument. On the other hand, if first the carrier is changed to 10 MHz, an invalid state 206 occurs as the FM deviation exceeds the hardware's limits. Under such circumstances, a detour is forced causing the 10 MHz input to become pending; instructing the hardware not to change yet; and providing the user with a message (e.g. blinking) indicating that the setting is pending. When the user subsequently enters a 1 kHz FM deviation, state 204 results which is valid and the hardware is accordingly altered. Additionally, all "pending" messages are removed. The above technique enables coupled entries to be made by the user without concern regarding the proper sequence of entries.

It should be understood that the foregoing description is only illustrative of the invention. Various alternatives and modifications can be devised by those skilled in the art without departing from the invention. For instance, while not preferred, a seperate select button could be emplaced on the face of RPG 14 so that it could be individually depressed for a selection action rather than depressing the entire knob. Accordingly, the present invention is intended to embrace all such alternatives, modifications and variations which all within the scope the appended claim.

## Claims

(1) In a multi function apparatus which includes processor control means, said processor control means enabled by a stored program and user selected inputs to configure subassemblies within said apparatus to perform a plurality of functions, the combination comprising:
display means for displaying screen configurations which indicate each of said functions, each said screen configuration including a plurality of control point fields selected from a limited set of types of control point fields common to all said functions, each type of control point field, when selected, enabling the performance of a predetermined operation incident to the performance of said function; and
user operable input means for selecting any displayed control point field, whereby all functions performable by said multi-function apparatus are operated through user interaction with and selection of one or more of said types of control point fields.

(2) The apparatus as defined in claim 1 wherein said user operable input means comprises a rotary transducer.

(3) The apparatus as defined in claim 2 wherein said rotary transducer includes means responsive to a depression of said transducer to enable said selection.

(4) The apparatus as defined in claim 2 further comprising:
means for generating a cursor indication in each displayed screen configuration, said rotary transducer providing inputs to said generating means which enable said cursor to move sequentially through said control point fields.

(5) The apparatus as defined in claim 4 further comprising:
means responsive to a non-rotary movement exerted on said rotary transducer to select a control spoint field where said cursor indication is displayed.

(6) The apparatus as defined in claim 5 wherein said input means further comprises:
a plurality of user-operated keys; and
mean responsive to the depression of one of said keys to move said cursor to a preselected position on said display, and to select any control point field at said preselected position.

(7) The apparatus as defined in claim 5 wherein said input means further comprises:
a plurality of user-operated keys; and immediate display means responsive to the depression of any said key to display on any displayed screen, a predetermined control point field.

(8) The apparatus as defined in claim 7 wherein said immediate display means moves said predetermined control-point field from one screen and displays it on another screen.

(9) The apparatus as defined in claim 8 wherein said functions performed by said multi-function apparatus comprise testing, measuring and signal generation.

(10) The apparatus as defined in claim 1 wherein said set of control point fields comprises:

a first field type for user entry of numeric data;

a second field type for user entry of strings of alphanumeric data; and

a third field type for user selection of one of a number of items sequentially displayable in said field.

(11) The apparatus as defined in claim 10 wherein said set of control point fields further comprises:

a fourth field type for user triggering of an immediate action within said apparatus; and

a fifth field type which causes a menu of measurement functions to be displayed.

(12) The apparatus as defined in claim 1 wherein said function requires a plurality of user entries via said displayed control point fields, the combination further comprising:

means for accumulating said plurality of entries and for delaying the commencement of an operation necessary for the performance of said function until all said plurality of user entries have been accummulated which are necessary to the performance of said operation.

(13) The apparatus as defined in claim 12 further comprising:

means for causing a control point field which displays one of said plurality of user entries to manifest an indication of a pending state, prior to all said plurality of userentries having been entered.

(14) The apparatus as defined in claim 13 further comprising:

means for inhibiting certain changes to said apparatus until all said plurality of entries for said operation have been entered.

(15) A method of locating, selecting, and changing a parameter displayed in a control point field among a plurality of different control point fields, comprising the steps of:

(a) providing a moveable cursor on a visual display, which is sequentially movable through displayed control point fields;

(b) moving said cursor directly from control point field to control point field by quantized rotary motion of a transducer element of a user interface to locate a desired control point field within said screen, and

(c) utilizing said transducer element of said user interface to effect a change of parameter of said control point field after the location thereof by said cursor.

(16) The method defined in claim 15 comprising the further step of:

(d) actuating said transducer element subsequent to said moving step (b) to enable selection of said control point field where said cursor is located, said utilizing step (c) not occurring until subsequent to said actuating step.

(17) The method defined in claim 16 where a plurality of screens are indicated on said visual display, said movement and actuation of said transducer element additionally enabling selection and display of a screen from a plurality sof screens.

(18) The method defined in claim 17 wherein said transducer element of said user interface is a press/release rotary pulse generator which may be manually rotated and operated in the same rotate and press/release mode for all control point fields of all screens in order to effect the location, selection and change in parameters of each of said control point field.

(19) The method defined in claim 18 wherein said user interface further includes a keyboard having dedicated function keys therein which may be operated independently of said rotary pulse generator to also control the location, selection and change of a parameter of selected control point fields.

FIG. 1

**FIG. 2**

SPECTRUM ANALYZER MODULE — 26

RF ANALYZER MODULE — 28

RECEIVER MODULE — 24

INPUT/OUTPUT MODULE — 22

OTHER USER CONNECTIONS — LF

DUPLEX OUT — RF

RF IN/OUT — RF

ANTENNA IN — RF

RF

RF

LF

LF

SIGNAL GENERATOR MODULE — 30

LF

OUTPUT MODULE — 34

LF

SINE SIGNALING SOURCES MODULE — 32

LF

MODULATION DISTRIBUTION MODULE — 36

RF = RADIO FREQUENCY (100 kHz – 1000 MHz)
LF = LOW FREQUENCY (20 Hz – 100 kHz)
DIG = DIGITAL BUS

DISPLAY — 12

DISPLAY CONTROLLER — 42

KEYBOARD/RPG 14 — 16

PROCESSOR/CONTROLLER — 20

TO/FROM ALL OTHER MODULES — DIG

DIG

DIG

DIG

VOLTMETER/COUNTER/SAMPLER/ — 40

VOLTAGE TAP POINTS

COUNTER TAP POINTS

SAMPLER TAP POINTS

DIG

# FIG.3

Receiver Test

Audio Measurements: Audio In

AC Level    [mV] ~50        [SINAD] ~70        [dB] ~72

23.45

8.00 ——■—— 12.5 —— 24.00
                    Avg

| 73 | 52 66 | 76 | | |
| RF Source | LF Source 1 | LF Source 2 | LF Analyzer | To Screen |
| Frequency | LFS 1 Dest | LFS 2 Dest | Filter 1 | RF Source ~56 |
| 100.00000 | FM | FM | 300 Hz | RF Anl ~58 |
| MHz | 3.000 | Off | | LF Anl ~60 |
| Amplitude | kHz | | Filter 2 | Scope |
| 1.000 | | | 3 kHz | Spec Anl |
| mV | LFS 1 Freq | LFS 2 Freq | Ext Load R | Signl Src |
| Rx Tx Cntl | 1000.0 | 1000.0 | 8.0 | Signl Anl |
| Auto/Manual | Hz | Hz | Ω | Cellular |
| Key:On/Off | | | | |

64, 54, 62

EP 0 416 731 A2

# FIG.4

RF Measurements: RF In/Out          Audio Measurements: FM Demod — Transmitter Test —

Frequency   MHz
100.000095   —101
Power     622   ///W   —103
14.95
—106      —107

FM Deviation   kHz   —102
2.975
Distn   %   —105
0.174   —108  —104  —109  —110

| RF Analyzer | LF Source 1 | LF Source 2 | LF Analyzer | To Screen |
|---|---|---|---|---|
| Auto Tune | LFS 1 Dest | LFS 2 Dest | Input | RF Source |
| 100.00010 | Audio Out | Audio Out | FM Demod | RF Anl |
| MHz | 1.000 | Off | Filter 1 | LF Anl |
|  | mV rms |  | 300 Hz HP | Scope |
|  |  |  | Filter 2 | Spec Anl |
|  | LFS 1 Freq | LFS 2 Freq | 3 kHz LP | Signl Src |
|  | 1000.0 | 1000.0 | De-emphasis | Signl Anl |
| Rx/Tx Cntl | Hz | Hz | 750 μS/Off | Radio Int |
| Auto Manual |  |  | Detector |  |
| Key:On/Off |  |  | pk ±/2 |  |

# FIG.5

| RF Measurements: RF In/Out | | Audio Measurements: | LF Analyzer — FM Demod |
|---|---|---|---|
| [Frequency] [MHz] | | FM Dev | [kHz] |
| 100.000095 | | 2.975 | |
| Power D[W] | | [Distn] | [%] |
| 14.95 | | 0.174 | |

| Input Path | Detectors | Scope/Spkr | Gain | To Screen |
|---|---|---|---|---|
| Input | Detector | Signl/Mon | Filters | |
| [FM Demod] | [pk ±/2] | Meas Point | [Auto/Hold] | [RF Source] |
| Filter 1 | pk Det Loc | [De-em/Exp] | [20 dB] | [RF Anl] |
| [300 Hz] | [De-em/Exp] | Spkr Vol | De-em/Exp | [LF Anl] |
| Filter 2 | Resp Time | [Pot/Off] | [Auto/Hold] | [Scope] |
| [3 kHz] | [Fast/Slow] | Spkr Mode | [40 dB] | [Spec Anl] |
| De-emphasis | | [Comp/ALC] | Notch | [Signl Src] |
| [750 µS/Off] | Audio In | Ext Load R | [Auto Hold] | [Signl Anl] |
| Expander | [Gnd Float] | [8.0] | [0 dB] | [Cellular] |
| [On/Off] | | Ω | | |

EP 0 416 731 A2

# FIG. 6

| RF Measurements: RF In/Out | | Audio Measurements: | RF Source FM Demod |
|---|---|---|---|
| [Frequency]    [MHz] | | FM Dev | [kHz] |
| 100.000095 | | 2.975 | |
| Power    [W] | | [Distn] | [%] |
| 14.95 | | 0.174 | |

| RF Source | LF Source 1 | LF Source 2 | Ext/Mic Mod | To Screen |
|---|---|---|---|---|
| Out:RF Dupl | LFS 1 Dest | LFS 2 Dest | Mod. In Dest | |
| Frequency | FM | FM | FM (/V) | RF Source |
| 100.00000 | 3.000 | Off | 3.000 | RF Anl |
| MHz | kHz | | kHz | LF Anl |
| Amplitude | LFS 1 Freq | LFS 2 Freq | Mic Pre-em | Score |
| 1.000 | 1.000 | 1.000 | Auto/Hold | Spec Anl |
| V | kHz | kHz | 750µS/Off | Signl Src |
| | | | | Signl Anl |
| Atten Hold | RF ALC | Mod Sense | FM Coupling | Cellular |
| On/Off | On/Off | Norm/Invert | AC / DC | |

EP 0 416 731 A2

# FIG. 7

**120**

```
Input : FM Demod                          Oscilloscope
Meas Point.: De-em/Exp                    Marker
                              Uncal       Time  [mS]
                                           3.123

                                          Lvl    G[kHz]
                                           1.234


                                          To Screen

                                          | RF Source |
                                          | RF Anl    |
                                          | LF Anl    |
                                          | Scope     |
                                          | Spec Anl  |
                                          | Signl Src |
                                          | Signl Anl |
                                          | Cellular  |
```

|          | **122**       | **124**       | **126**      | **128**     |
|----------|---------------|---------------|--------------|-------------|
| Controls | Vert/div      | Vert Offset   | Time/div     |             |
| Main     | I kHz         | 0.00          | 200 µS       |             |
|          |               |               | %            |             |

**130**

| Controls | Trig Source | Pos /Neg     | Trig Level |
|----------|-------------|--------------|------------|
| Trigger  | RFS On      | Cont/Single  | 0.00       |
|          | Auto /Norm  | Reset        | %          |

| Controls | Position | Marker    | Marker    |
|----------|----------|-----------|-----------|
| Marker   | 0.00     | To + Peak | To −Peak  |
|          | %        |           |           |

# FIG. 8

| Input:RF In/Out | | | | Spectrum Analyzer |
|---|---|---|---|---|

**Marker**

Freq [MHz]
100.00010

Lvl [dBm]
30.0

**To Screen**

| RF Source |
|---|
| RF Ant |
| LF Ant |
| Scope |
| Spec Ant |
| Signl Src |
| Signl Ant |
| Cellular |

*140*

*130*

| Controls | Auto Tune | Ref Level | Span |
|---|---|---|---|
| Main | 100.00010 MHz | 50.0 dBm | Full Span / Bw 30 kHz |

*132*

| Controls | Offs Freq | Amplitude | Sweep Mode |
|---|---|---|---|
| Source / Track/Fixed | 600.00000 MHz | −20.0 dBm | Norm/Invert |

*134*

| Controls | Frequency | Amplitude | Destination |
|---|---|---|---|
| Source / Track/Fixed | 100.00000 MHz | −50.0 dBm | Out: RF/Dupl |

*136*

| Controls | Position | | |
|---|---|---|---|
| Marker | 0.00 % | Peak Search | Mkr –> CF |

*138*

| Controls | RF Path | Attenuator | Trace Math |
|---|---|---|---|
| Path / Math | In: RF/Ant | Auto / Hold / 20 dB | A Only / A-B / Save B |

# FIG. 9

NUMERIC ENTRY FIELD

ISOLATED

LOCATED

⊗/ENTER    ⊗/ENTER

SELECTED

150

VALUE ENTRY    n/BS

n

UNITS/ENTER/⊗

UNITS/ ↑ /↓ ·x10/÷10/ON/OFF

INCR SET    DISPLAY INCR    UNITS/x10/÷10    n    INCR ENTRY    n/BS

ENTER/ ⊗ / ↑ / ↓ /⌒    UNITS/ENTER/ ⊗

REF SET    DISPLAY REF.    UNITS    n    REF ENTRY    n/BS

ENTER/ ⊗ /ON/OFF

UNITS/ENTER/ ⊗

1

LEGEND

⌒ =ROTATION OF RPG 1 CLICK
n =SINGLE KEYSTROKE OF A NUMERIC KEY
UNITS=SINGLE KEY STROKE OF A UNITS KEY
BS=BACK SPACE KEY
⊗ =DEPRESSION OF RPG 14
REF SET=DEPRESSION OF REF SET KEY
INCR SET=DEPRESSION OF INCR SET KEY
ENTER=DEPRESSION OF ENTER KEY
INCR x 10=DEPRESSION OF INCR x 10 KEY
INCR - 10=    "    " INCR - 10 KEY
METER=    "    " METER KEY
AVG=    "    " AVG KEY
HI LIMIT=    "    " HI LIMIT KEY
LO LIMIT=    "    " LO·LIMIT KEY
ON/OFF=    "    " ON/OFF KEY

18

EP 0 416 731 A2

# FIG. 10

STRING ENTRY FIELD

# FIG. 11

ONE OF MANY FIELD

# FIG. 12

IMMEDIATE ACTION FIELD

19

## MEASUREMENT UNIT FIELD

ISOLATED

LOCATED

SELECTED

⊗/ENTER

⌐∿/↓/↑

⊗/ENTER

UNITS/ON/OFF

LO LIMIT

HI LIMIT

REF SET

AVG

METER

**FIG. 13**

UNITS — DISPLAY LO LIM — n — LO LIM ENTRY — ENTER/⊗/ON/OFF — n/BS — UNITS/ENTER/⊗

UNITS — DISPLAY HI LIM — n — HI LIM ENTRY — n/BS

UNITS — DISPLAY REF — n — REF ENTRY — n/BS

DISPLAY AVG — n — AVG ENTRY — n/BS

"ON/OFF" or "ON/OFF" from menu

METER MENU — ⊗/ENTER

"LO END" — DISPLAY LO END — UNITS — n — LO END ENTRY — n/BS

"HI END" — DISPLAY HI END — UNITS — n — HI END ENTRY — n/BS

"INTERVALS" — DISPLAY INTERVALS — n — INTERVALS ENTRY — n/BS

"LABELS" — DISPLAY LABEL STATUS

↓/O ON/OFF, ENTER/⊗

ENTER/⊗

UNITS/ENTER/⊗

# FIG. 14

All valid states; make settings in hardware each step.

_202_

1000 MHz carrier freq.
1 KHz Dev. FM

_200_

_204_

1000 MHz carrier freq.
100 KHz deviation FM

change FM

Change carrier

10 MHz carrier freq.
1 KHz deviation FM

Change carrier

*INVALID STATE*

Change FM

10 MHx carrier freq.
100 MHz deviation FM

_206_

- update all hardware
- remove user message

- remember "10 MHz is desired"
- don't change hardware yet
- give user a message indicating his setting is pending

RF Generator -
 FM deviation limited by hardware
 to 0.01% of carrier frequency